# FASCICULE DE BREVET EUROPEEN

(11) **EP 3 363 056 B1**
(45) Date de publication et mention de la délivrance du brevet: **04.12.2024**
(21) Numéro de dépôt: 16791653.5
(22) Date de dépôt: 05.10.2016
(51) Int. Cl.: H10N 50/10, G11C 11/16

(54) **POINT MEMOIRE MAGNETIQUE**
MAGNETISCHES SPEICHERELEMENT
MAGNETIC MEMORY ELEMENT

(30) Priorité: 16.10.2015 FR 1559914
(43) Date de publication de la demande: 22.08.2018
(73) Titulaire: Centre National de la Recherche Scientifique, 75794 Paris Cedex 16 (FR); Commissariat à l'Energie Atomique et aux Energies Alternatives, 75015 Paris (FR)
(72) Inventeur: GAUDIN, Gilles, 38700 Le Sappey En Chartreuse (FR); MIRON, Ioan Mihai, 38000 Grenoble (FR); BOULLE, Olivier, 38000 Grenoble (FR); CHENATTUKUZHIYIL, Safeer, Malappuram Kerala 673642 (IN)
(74) Mandataire: IPAZ
(86) Numéro de dépôt international: PCT/FR2016/052568
(87) Numéro de publication internationale: WO 2017/064394

(56) Documents cités:
- EP-A1- 3 360 172
- WO-A1-2016/113503
- US-A1- 2009 273 972
- US-A1- 2010 207 220
- US-A1- 2012 020 152
- US-B1- 6 707 122

## Description

La présente demande de brevet revendique la priorité de la demande de brevet français FR15/59914.

### Domaine

La présente demande concerne un point mémoire magnétique, et plus particulièrement un point mémoire magnétique de type à retournement induit par un courant.

### Exposé de l'art antérieur

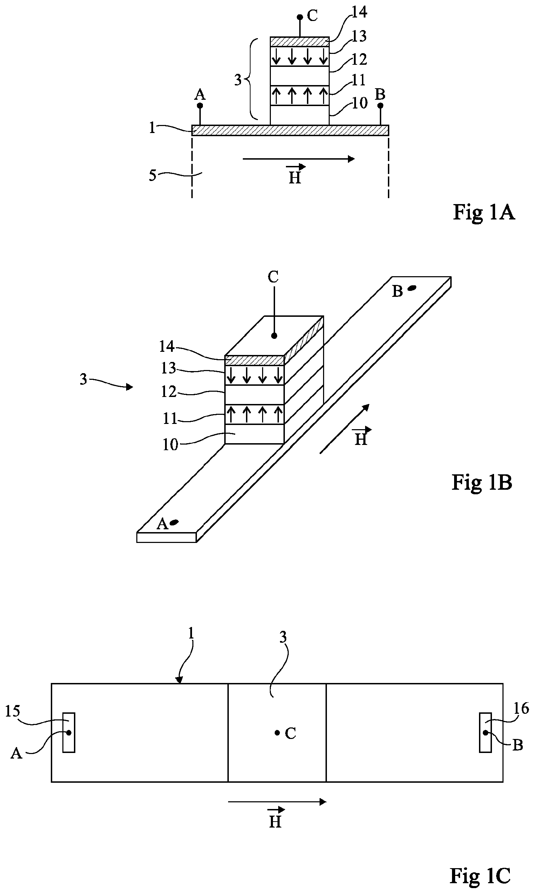

Le brevet français N°2 963 152 décrit un point mémoire magnétique tel que représenté schématiquement en figures 1A, 1B et 1C. Les figures 1A et 1B représentent respectivement une vue en coupe et une vue en perspective d'un point mémoire magnétique tel que décrit en relation avec les figures 1c-1f, 2a-2b et 3a-3d du brevet français N°2 963 152. La figure 1C est une vue de dessus simplifiée de ce point mémoire.

Comme l'illustrent les figures 1A et 1B, ce point mémoire comprend, au-dessus d'une piste conductrice 1, un plot 3. Le plot 3 comprend un empilement de régions dont chacune est formée d'une portion d'une couche mince ou d'un empilement de plusieurs couches minces. La piste conductrice 1 est par exemple formée sur un substrat 5 constitué d'une plaquette de silicium revêtue d'une couche d'oxyde de silicium et est connectée entre des bornes A et B. L'empilement constituant le plot 3 comprend successivement à partir de la piste 1, une région 10 en un matériau conducteur non magnétique, une région 11 en un matériau magnétique, une région 12 en un matériau non magnétique, une région 13 en un matériau magnétique et une électrode 14. Le matériau de la couche 12 peut être conducteur ; c'est de préférence un matériau isolant suffisamment mince pour pouvoir être traversé par des électrons par effet tunnel. Il existe une différence structurelle entre les régions non magnétiques 10 et 12 de façon à avoir un système asymétrique dans une direction orthogonale au plan des couches. Cette différence peut résulter notamment d'une différence de matériau, d'épaisseur, ou de mode de croissance de ces couches.

Des listes de matériaux pouvant constituer les diverses couches sont données dans le brevet susmentionné. Les matériaux magnétiques des régions 11 et 13 sont formés dans des conditions telles qu'ils présentent une aimantation dirigée orthogonalement au plan des couches. Le matériau magnétique de la couche 13 est formé dans des conditions telles qu'il conserve une aimantation intangible (couche piégée). La couche d'électrode supérieure 14 est connectée à une borne C.

La programmation du point mémoire est effectuée en faisant circuler un courant entre les bornes A et B, tandis qu'un champ H orienté horizontalement (parallèlement au plan des couches et à la direction du courant entre les bornes A et B) est appliqué.

Selon les sens relatifs du courant entre les bornes A et B et du vecteur de champ H, la couche 11 est programmée de sorte que son aimantation s'oriente vers le haut ou vers le bas.

Pour la lecture de ce point mémoire, une tension est appliquée entre la borne C et l'une ou l'autre des bornes A et B.

Le courant résultant entre la borne C et l'une ou l'autre des bornes A et B prend des valeurs différentes selon le sens relatif des aimantations des couches 11 et 13 : valeur haute si les deux aimantations sont dans le même sens et valeur basse si les deux aimantations sont de sens opposés. Une caractéristique du point mémoire décrit ci-dessus est que sa programmation se fait grâce à un courant circulant entre les bornes A et B et à un champ magnétique appliqué dans le plan des couches, parallèlement au courant. Aucun courant ne circule de la borne A ou B vers la borne C lors de la programmation. Ceci présente l'avantage de dissocier complètement les opérations de lecture et d'écriture du point mémoire.

De nombreuses variantes de réalisation sont possibles. Notamment, chaque couche décrite précédemment peut être constituée d'un empilement de couches de façon connue dans la technique pour acquérir les caractéristiques souhaitées.

La portion de couche 10 en un matériau conducteur non magnétique peut être omise, à condition que la piste 1 soit en un matériau non magnétique convenant à la croissance de la couche magnétique 11. La piste 1 peut alors présenter une surépaisseur sous le plot 3. Pour que le retournement de l'aimantation dans la couche 11 puisse se faire, il faut aussi que des couples de spin- orbite soient présents dans la couche magnétique. Pour ce faire, il faut par exemple que la couche en contact avec cette couche 11 (ou séparée d'elle par une couche séparatrice fine) soit constituée d'un matériau ou composée de matériaux à fort couplage spin-orbite. Une autre solution est, par exemple, que le contact entre la couche magnétique 11 et l'une ou l'autre des couches 10 et 12 crée ce couplage spin-orbite ; c'est ce qui peut par exemple arriver par hybridation de la couche magnétique 11 avec la couche 12 si celle-ci est constituée d'un isolant (voir "Spin-orbit coupling effect by minority interface résonance states in single- crystal magnetic tunnel junctions", Y. Lu et al . Physical Review B, Vol. 86, p.184420 (2012)).

On notera que le point mémoire des figures 1A et 1B peut être décomposé en deux éléments : un élément de mémorisation comprenant la piste 1 munie des bornes A et B et les portions de couches 10, 11 et 12, et un élément de lecture comprenant dans l'exemple donné ci-dessus les couches 13 et 14 et l'électrode C. Avec le même élément de mémorisation, divers modes de lecture pourraient être envisagés, par exemple une lecture optique.

La figure 1C est une vue de dessus simplifiée du plot 3. Seule la piste 1 et le plot 3 sont représentés, ainsi que les bornes A et B connectées à des contacts 15 et 16.

Comme on l'a indiqué précédemment, le point mémoire des figures 1A à 1C est programmable par l'application d'un courant entre les bornes A et B simultanément à l'application d'un champ magnétique ayant une composante non nulle selon la direction du courant. Des exemples de moyens de génération d'un champ magnétique sont donnés dans la demande de brevet susmentionnée. L'application d'un champ externe ou la réalisation de couches magnétiques spécifiques propres à créer le champ H pose des problèmes de réalisation pratique.

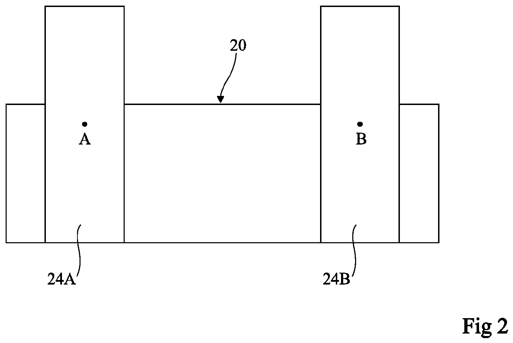

La demande de brevet US 2014/0010004 décrit un point mémoire magnétique qui peut être programmé par application d'un courant en 1 ' absence de champ magnétique . La figure 2 est une vue de dessous schématique d'un point mémoire magnétique correspondant à la figure 18A de cette demande de brevet. Un plot magnétique 20 comprend un empilement de portions de couches similaires aux couches du plot magnétique 3 décrit en relation avec les figures 1A à 1C. Le plot 20 a une forme de rectangle allongé. Deux électrodes 24A et 24B distinctes disposées aux extrémités du rectangle et dépassant d'un même grand côté du rectangle sont connectées à des bornes A et B et permettent de faire circuler un courant dans la couche magnétique 11. Le sens de l'écoulement du courant, de la borne A vers la borne B ou de la borne B vers la borne A, définit la valeur programmée. Une telle configuration du point mémoire comportant des électrodes distinctes sous le plot pose divers problèmes de réalisation.

Par ailleurs, le document WO 2016/113503 A1 divulgue un point mémoire magnétique présentant une asymétrie géométrique introduite par le plot, la piste conductrice étant rectiligne. Cette asymétrie permet de se passer d'un champ magnétique externe de polarisation pour effectuer le basculement de l'aimantation de la couche magnétique libre du plot lors du stockage d'une information binaire.

Le document EP 3 360 172 A divulgue un point mémoire magnétique comportant une portion centrale, portant le plot, d'où sont issues deux paires de branches conductrices. Pour le basculement de l'aimantation de la couche magnétique libre du plot dans un sens, une paire de branches est sélectionnée pour l'injection d'un courant d'écriture (quel que soit le sens de circulation de ce courant entre les branches de la paire sélectionnée), et pour le basculement de l'aimantation de la couche magnétique libre du plot dans un sens opposée, l'autre paire de branches est sélectionnée pour l'injection du courant d'écriture (quel que soit le sens de circulation de ce courant entre les branches de la paire sélectionnée).

Les documents US2009/0273972 A1 et US 2010/0207220 A1 divulguent des composants magnétiques comprenant un élément multicouche positionné au centre de quatre branches conductrices.

Il existe un besoin pour un point mémoire programmable par application d'un courant en l'absence de champ magnétique qui soit simple à réaliser et sensible à de faibles courants.

### Résumé

L'invention a pour objet un point mémoire magnétique et un procédé de programmation d'un tel point mémoire magnétique conforme aux revendications annexées.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B et 1C sont respectivement une vue en coupe et en perspective et de dessus d'un point mémoire magnétique selon l'état de la technique
la figure 2 est une vue de dessous schématique d'un point mémoire magnétique selon l'état de la technique;
les figures 3A et 3B sont respectivement une vue schématique en perspective et une vue schématique de dessus d'un mode de réalisation d'un point mémoire magnétique selon l'invention;
les figures 4A à 4C sont des vues de dessus schématiques d'autres modes de réalisation d'un point mémoire magnétique; et les figures 5A à 5C sont des vues de dessus schématiques d'autres modes de réalisation d'un point mémoire magnétique selon l'invention.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés.

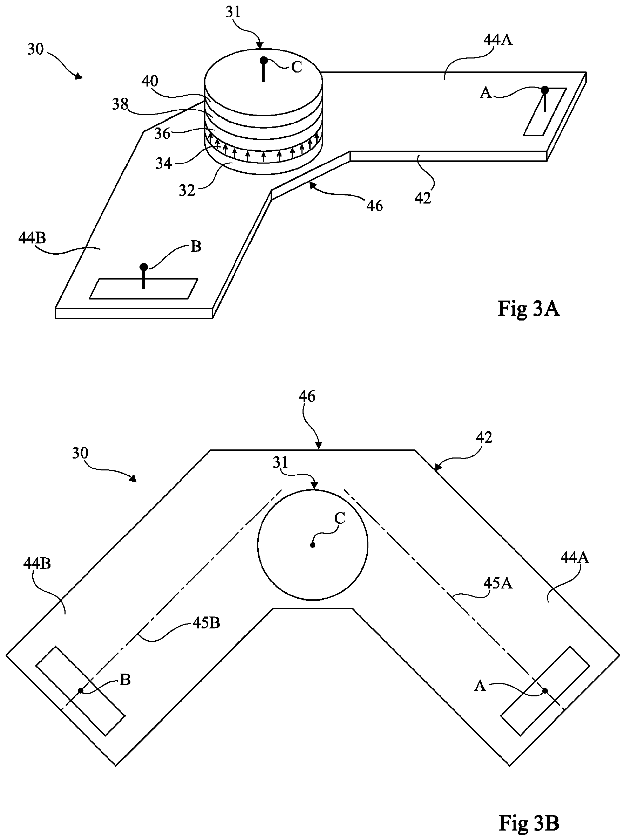

Dans la description qui suit, sauf précision contraire, lorsque l'on fait référence à des qualificatifs de position absolue, tels que les termes "haut", "bas", etc., ou relative, tels que les termes "dessus", "dessous", "supérieur", etc., il est fait référence à l'orientation de l'élément concerné dans les figures 1A, 1B et 3A. Sauf précision contraire, les expressions "sensiblement" et "de l'ordre de" signifient, s 'agissant d'une orientation, à 10 degrés près, de préférence à 5 degrés près.

Les figures 3A et 3B sont respectivement une vue schématique en perspective et une vue schématique de dessus d'un mode de réalisation d'un point mémoire magnétique 30.

Le point mémoire magnétique 30 comprend un plot 31. Le plot 31 comprend, de bas en haut, une portion de couche conductrice 32, une portion de couche magnétique programmable 34 ayant une aimantation orthogonale au plan des couches, une portion de couche non magnétique 36 différente de la couche 32, une portion de couche magnétique 38 et une électrode 40. La couche conductrice 32 et la couche non magnétique 36 diffèrent par leur épaisseur, leur composition ou leur structure. L'électrode 40 est reliée à une borne C. Les couches 32, 34, 36, 38 et 40 sont similaires aux couches minces formant les régions respectives 10, 11, 12, 13 et 14 décrites précédemment en relation avec les figures 1A à 1C.

Le plot 31 est formé dans sa totalité sur une piste conductrice 42 munie à ses extrémités de contacts avec des bornes A et B. La piste 42 est coudée et comprend deux bras 44A et 44B d'axes médians respectifs 45A et 45B. L'angle entre les axes médians 45A et 45B peut être compris entre 30° et 150°, de préférence entre 60° et 120°, par exemple de l'ordre d'un angle droit. Les deux bras 44A et 44B se rejoignent au niveau d'une portion centrale 46 de la piste 42. Le plot 31 a en vue de dessus la forme d'un disque et est disposé sur la portion centrale 46 dans une position décentrée par rapport aux axes médians 45A et 45B. Un observateur placé sur l'axe médian 45A du bras 44A et regardant vers le plot selon l'axe médian 45A voit le plot essentiellement sur sa gauche. Si l'observateur se place sur l'axe médian 45B et regarde vers le plot selon l'axe médian 45B, il voit le plot essentiellement sur sa droite.

En fonctionnement, le point mémoire 30 est connecté à un dispositif non représenté adapté à faire circuler un courant entre les bornes A et B. Les inventeurs ont observé que le passage du courant de la borne A vers la borne B impose une orientation à l'aimantation de la couche programmable 34. Le passage du courant de la borne B vers la borne A impose l'orientation inverse. Ainsi, la programmation du point mémoire est obtenue en l'absence de dispositif propre à créer un champ magnétique.

On notera que la piste 42 est continue sous le plot 31 et s'étend autour du plot. Lorsque le courant de programmation circule entre les bornes A et B, le cheminement du courant prend une configuration particulière dans la piste sous le plot et autour du plot, ainsi que dans les couches 32 et 34 du plot. En effet, le courant provenant du bras 44A voit le plot sur sa gauche. Le plot 31 est vu sur la droite par un courant provenant du bras 44B. Cette configuration du courant dans le plot, sous le plot et autour du plot permet la programmation.

On soulignera que le plot 31 se situe intégralement sur la piste 42, ce qui permet de former facilement le plot à partir de la surface de la piste 42. De ce fait, la couche conductrice 32 peut être omise, à condition que le matériau et le procédé de fabrication de la piste 42 conviennent à la croissance de la couche magnétique programmable 34.

La lecture du point mémoire 30 s'obtient, d'une manière similaire à la lecture décrite en relation avec les figures 1A et 1B, en mesurant une résistance entre la borne C et la borne A ou B. Les couches supérieures 38 et 40, ainsi que la borne C, constituent un ensemble de lecture. A titre de variante, l'ensemble de lecture peut être omis, et remplacé par exemple par un dispositif de lecture électronique utilisant l'effet Hall extraordinaire ou encore un dispositif de lecture optique.

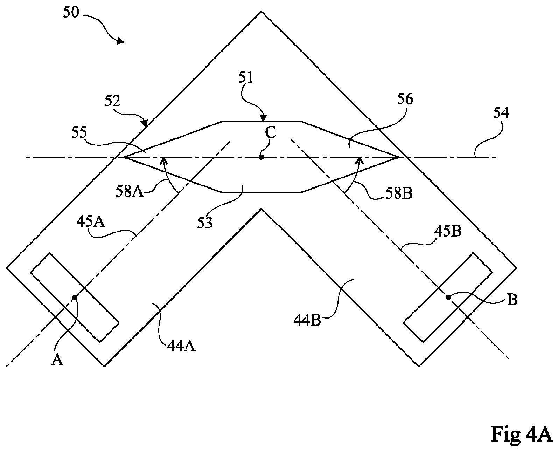

Les figures 4A à 5C sont des vues de dessus schématiques d'autres modes de réalisation d'un point mémoire magnétique. Par souci de clarté, des éléments des points mémoire décrits en relation avec les figures 4A à 5C ayant le même rôle que des éléments du point mémoire 30 des figures 3A et 3B sont désignés par de mêmes références. Chacun des points mémoire magnétiques illustrés en figures 4A à 5C comprend un plot intégralement disposé sur une piste. Chaque plot comprend une portion d'un empilement de couches semblable à l'empilement de couches du plot 31 décrit en relation avec les figures 3A et 3B. Chaque plot est surmonté d'un contact avec une borne C.

En figure 4A un point magnétique 50 comprend un plot 51 formé sur une piste conductrice 52. La piste conductrice comprend un coude central entre deux bras 44A et 44B, et le plot 51 est disposé sur le coude. L'angle entre les bras peut être compris entre 30° et 150°, de préférence entre 60° et 120°, par exemple de l'ordre d'un angle droit. Les bras 44A et 44B ont des axes médians respectifs 45A et 45B et sont munis à leurs extrémités de contacts avec des bornes respectives A et B. En vue de dessus, le plot 51 a la forme d'un rectangle 53 allongé qui se prolonge à partir de chacun de ses petits côtés par deux pointes 55, 56. L'axe 54 du rectangle fait des angles compris entre 30 et 60°, par exemple sensiblement égaux à 45°, avec les axes médians 45A et 45B, les deux bras 44A et 44B se situant d'un même côté de l'axe 54. L'axe médian 45A et l'axe 54 font un angle aigu 58A orienté dans le sens horaire, tandis que l'axe médian 45B et l'axe 54 font un angle aigu 58B orienté dans le sens antihoraire.

Un courant circulant selon l'axe médian 45A vers le plot 51 voit la partie la plus proche du plot sur sa gauche. Un courant circulant selon l'axe médian 45B vers le plot 51 voit la partie la plus proche du plot sur sa droite. Ainsi, la circulation d'un courant entre les bornes A et B impose une orientation à 1 ' aimantation de la couche programmable 34 dans les parties du plot 51 les plus proches des bras 44A et 44B. Les inventeurs ont observé et démontré que, de manière remarquable, cette orientation imposée localement s'étend alors à l'aimantation de la couche 34 de l'ensemble du plot. Ainsi, le point mémoire magnétique 50 est programmable par un courant circulant entre les bornes A et B sans qu'il soit besoin d'ajouter un champ magnétique.

De plus, les parties du plot 51 les plus proches des bras 44A et 44B ont des formes de pointes. Les inventeurs ont observé et démontré que la présence de telles pointes permet avantageusement de programmer le point mémoire avec un courant réduit.

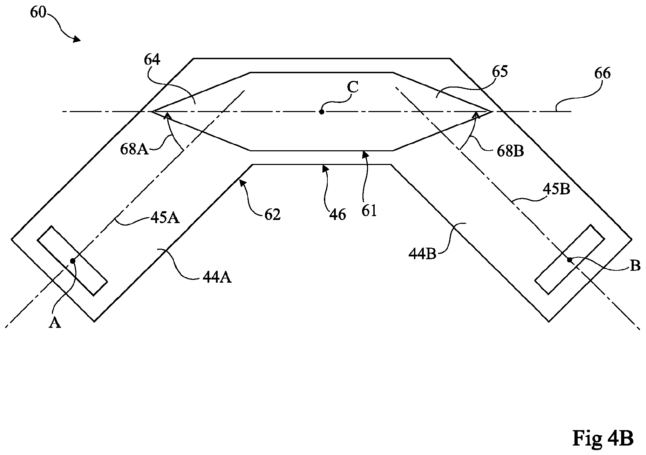

La figure 4B représente une variante 60 du point mémoire 50 décrit ci-dessus. Le point mémoire 60 comprend un plot 61 sur une piste 62. La piste 62 a des bras 44A et 44B disposés de la même manière que les bras 44A et 44B de la piste 52 du point mémoire 50. Les bras sont reliés à une portion centrale 46. Le plot 61 a une forme et une disposition similaires à celles du plot 51, et s'étire en deux pointes 64 et 65 selon un axe 66. L'axe 66 forme avec les axes médians 45A et 45B des angles 68A et 68B identiques aux angles 58A et 58B du point mémoire 50.

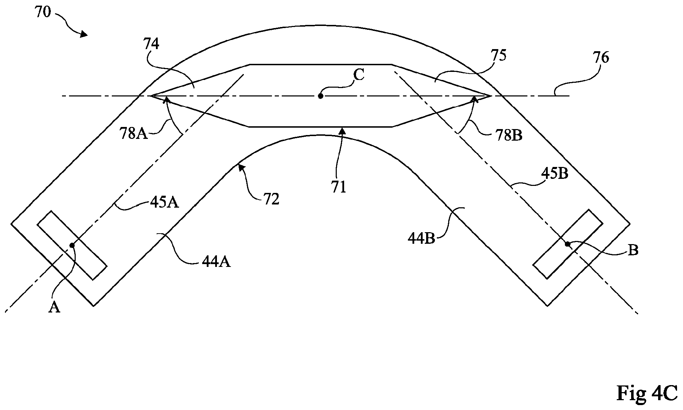

La figure 4C représente une autre variante du point mémoire 50 décrit ci-dessus. Le point mémoire 70 comprend un plot 71 sur une piste 72. La piste 72 a des bras 44A et 44B disposés de la même manière que les bras 44A et 44B de la piste 52 du point mémoire 50. Les deux bras reliés à une portion centrale forment un coude arrondi en forme de virage. Le plot 71 a une forme et une disposition similaires à celles du plot 51, et s'étire en deux pointes 74 et 75 selon un axe 76. L'axe 76 forme avec les axes médians 45A et 45B des angles 78A et 78B identiques aux angles 58A et 58B du point mémoire 50.

Les coudes des pistes 62 et 72 représentées en figures 4B et 4C permettent aux plots 61 et 71 d'être plus allongés que le plot 51 de la figure 4A et d'avoir des pointes plus acérées.

De plus, la forme de chacun de ces coudes permet d'éviter qu'une partie du courant passe dans des parties du coude éloignées du plot. De ce fait, les points mémoire 61 et 71 des figures 4B et 4C peuvent être programmés avec un courant inférieur, tout en conservant la forme simple du plot 51 de la figure 4A.

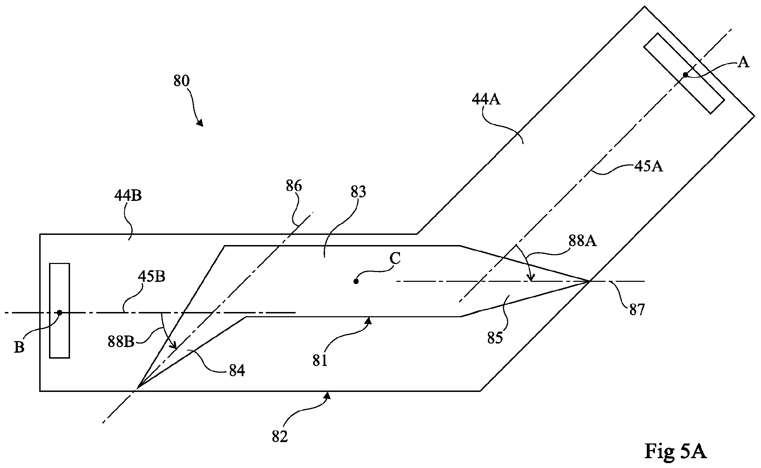

En figure 5A, un point mémoire magnétique 80 comprend un plot 81 disposé sur une piste 82. La piste conductrice comprend un coude central entre deux bras 44A et 44B, et le plot 81 est disposé sur le coude. L'angle entre les bras peut être compris entre 15° et 75°, de préférence entre 30° et 60°, par exemple de l'ordre de 45°. Le plot 81 comprend une partie centrale 83 disposée, sur la portion centrale de la piste, sur le bras 44B près du bord situé du même côté que le bras 44A. La partie centrale 83 a la forme d'un rectangle allongé dans la direction du bras 44B. La partie centrale 83 se prolonge à partir de chacun de ses petits côtés par des portions 84 et 85 en forme de pointe. La portion 84 s'étend du côté du bras 44B selon un axe 86 faisant un angle aigu compris entre 30° et 60°, par exemple sensiblement égal à 45° avec l'axe médian 45B. La portion 85 s'étend en vis-à-vis du bras 44A selon l'axe médian 87 de la partie centrale 83 et sa pointe se rapproche du bord du bras 44A opposé au bras 44B. L'axe médian 45A et l'axe 87 font un angle aigu 88A orienté dans le sens horaire, tandis que l'axe médian 45B et l'axe 86 font un angle aigu 88B orienté dans le sens antihoraire.

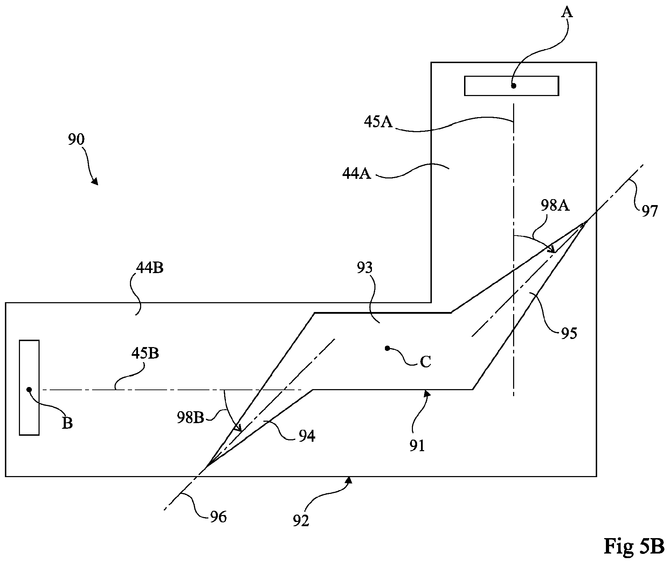

En figure 5B, un point mémoire magnétique 90 comprend un plot 91 disposé sur une piste 92. La piste conductrice comprend un coude central entre deux bras 44A et 44B, et le plot 91 est disposé sur le coude. L'angle entre les bras peut être compris entre 30° et 150°, de préférence entre 60° et 120°, par exemple de l'ordre d'un angle droit. Le plot 91 comprend une partie centrale 93 disposée sur la portion centrale de la piste sur le bras 44B près du bord situé du même côté que le bras 44A. La partie centrale 93 a une forme de rectangle allongé dont les grands côtés sont parallèles à l'axe médian 45B. La partie centrale 93 se prolonge à partir de ses petits côtés par des portions en forme de pointe 94 et 95. La portion 94 s'étend du côté du bras 44B dans une direction 96 faisant avec l'axe médian 45B un angle compris entre 30° et 60°, par exemple sensiblement égal à 45°. La portion 95 s'étend en regard du bras 44A dans une direction 97 faisant avec l'axe médian 45A un angle compris entre 30° et 60°, par exemple sensiblement égal à 45°. L'axe médian 45A et l'axe 97 font un angle aigu 98A orienté dans le sens horaire, tandis que l'axe médian 45B et l'axe 96 font un angle aigu 98B orienté dans le sens antihoraire. Les points mémoires 80 et 90 représentés en figures 5A et 5B ont donc des portions en forme de pointe proches des bras. L'orientation de ces portions est telle que, lorsqu'un observateur situé sur l'axe médian du bras 44A regarde le plot dans la direction de l'axe médian, il voit la pointe sur sa gauche. La pointe est sur la droite d'un observateur situé sur l'axe médian du bras 44B et regardant le plot. Ainsi, les points mémoire 80 et 90 peuvent être programmés de la même manière que les points mémoire décrits précédemment en relation avec les figures 3A, 3B et 4A à 4C. Cependant, les pointes des plots des points mémoire 80 et 90 sont plus aiguës que les pointes des plots des points mémoire des figures 4A à 4C, ce qui permet une réduction supplémentaire avantageuse du courant de programmation.

Bien que les exemples particuliers de plots décrits en relation avec les figures 4A à 5B comprennent des portions en forme de pointe ayant des angles vifs, les formes réelles peuvent être arrondies. Les rayons de courbures peuvent être, par exemple, compris entre 1 et 10 nm. A titre de variante, les portions en forme de pointe peuvent être remplacées par des portions arrondies allongées dans la même direction.

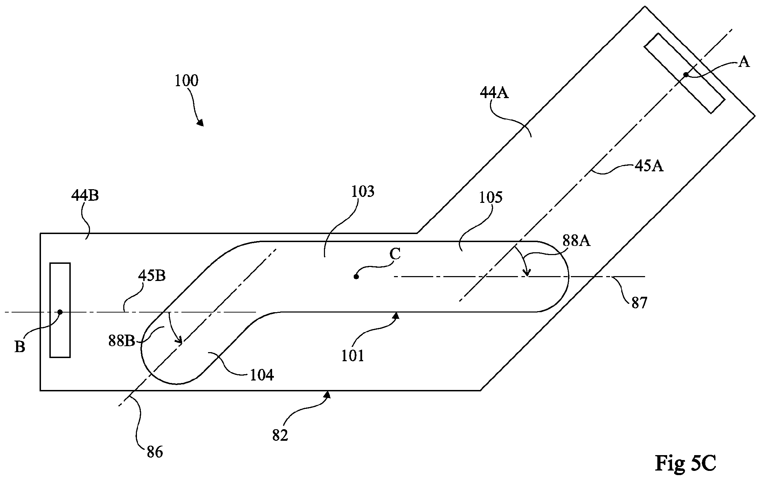

La figure 5C représente une telle variante du point mémoire 80 de la figure 5A. Un point mémoire 100 comprend un plot 101 disposé sur la piste 82 du point mémoire 80. Le plot 101 comprend une portion centrale 103 similaire à la portion 83 du plot 80 et disposée de manière identique sur la branche 44B. La portion 103 se prolonge par des portions arrondies allongées selon les directions 86 et 87 de la figure 5A.

Un avantage du point mémoire 100 est que les formes arrondies du plot 101 en facilitent la réalisation, plus particulièrement lorsque les dimensions sont faibles. A titre d'exemple, les dimensions dans un sens orthogonal aux axes médians 45A et 45B, ou largeurs, des bras 44A et 44B des figures 3A à 5C, sont comprises entre 10 nm et 200 nm. Les largeurs des bras 44A et 44B peuvent être différentes. A titre d'exemple, la densité de courant utilisée pour programmer le point magnétique est compris entre 10 A/cm et 108 A/cm2 .

La couche magnétique programmable peut comporter un alliage présentant une anisotropie magnétique perpendiculaire propre, notamment FePt, FePd, CoPt, ou un alliage de terre rare / métal de transition, notamment GdCo, TdFeCo. La couche magnétique programmable peut comporter un métal ou un alliage présentant dans l'empilement une anisotropie magnétique perpendiculaire induite par les interfaces, notamment Co, Fe, CoFe, Ni, CoNi.

L'une des couches 32, 36 prenant en sandwich la couche magnétique programmable 34 peut être en un métal non magnétique, tel que Pt, W, Ir, Ru, Pd, Cu, Au, Bi, Hf ou en alliage de ces métaux ou sous la forme d'un empilement de plusieurs couches de chacun de ces métaux.

La couche conductrice 32 peut être en un matériau non magnétique ou antiferromagnétique. A titre d'exemple de matériaux antiferromagnétiques, on peut citer des alliages à base de Mn tels que IrMn, FeMn, PtMn, ou des alliages de ces composés comme PtFeMn ou des oxydes tels ou CoOx ou NiOx.

La couche non magnétique 36 surmontant la couche magnétique programmable peut être en un oxyde diélectrique tel que SiOx, AIOx, MgOx, TaOx, HfOx, ou en un nitrure diélectrique tel que SiN, BNx, d'une épaisseur propre à autoriser un effet tunnel.

L'épaisseur d'une des couches 32, 36 prenant en sandwich la couche magnétique programmable peut être comprise entre 0,5 nm et 200 nm, plus particulièrement entre 0,5 nm et 100 nm, et préférentiellement inférieure à 3 nm.

L'épaisseur de la couche magnétique programmable peut être inférieure à 3 nm.

La couche magnétique 38 de l'ensemble de lecture peut être en un matériau magnétique, ou en un composé de matériaux magnétiques, ou comprendre plusieurs couches de matériaux magnétiques et non magnétiques. Des modes de réalisation particuliers ont été décrits. Diverses variantes et modifications apparaîtront à l'homme de l'art. En particulier, bien que des configurations particulières aient été décrites, d'autres configurations sont possibles dans la condition que, pour chaque bras, un observateur extérieur placé sur le bras regardant le plot selon la direction de l'axe médian du bras voie la partie du plot la plus proche de lui en majorité sur sa gauche pour l'un des bras, et en majorité sur sa droite pour 1 ' autre des bras .

De plus, chaque couche des plots des points magnétiques décrits précédemment peut être constituée d'un empilement de couches de façon connue dans la technique pour acquérir les caractéristiques souhaitées.

En outre, bien que, dans les points mémoire magnétiques décrits, les bras soient rectilignes, les bras peuvent aussi être incurvés en ayant dans leurs parties les plus proches du plot la même direction que les bras rectilignes, et ayant des axes médians définis par les axes médians des bras rectilignes.

## Revendications

1. Point mémoire magnétique, comprenant :
un plot (31 ; 51 ; 61 ; 71 ; 81 ; 91 ; 101) comportant une portion de couche magnétique (34) entre une portion de couche conductrice (32) et une portion de couche non magnétique (36), la couche magnétique ayant une aimantation perpendiculaire au plan des couches ; et
une unique piste conductrice coudée (42 ; 52 ; 62 ; 72 ; 82 ; 92 ; 102) comportant une portion centrale prolongée par uniquement deux bras (44A, 44B), 1e plot étant disposé en totalité sur la piste,
dans lequel, pour chaque bras, un courant circulant vers le plot selon l'axe médian (45A, 45B) du bras voit la partie du plot la plus proche du bras en majorité sur sa gauche pour l'un des bras (44A), et en majorité sur sa droite pour l'autre des bras (44B).

2. Point mémoire magnétique selon la revendication 1, dans lequel la couche conductrice (34) et la couche non magnétique (36) diffèrent par leur épaisseur, leur composition ou leur structure.

3. Point mémoire magnétique selon la revendication 1 ou 2, dans lequel la couche magnétique (34) a une épaisseur inférieure à 3 nm.

4. Point mémoire magnétique (30) selon l'une quelconque des revendications 1 à 3, dans lequel le plot (31) vu de dessus a la forme d'un disque.

5. Point mémoire magnétique (50 ; 60 ; 70 ; 80 ; 90 ;100) selon l'une quelconque des revendications 1 à 3, dans lequel, pour chaque bras (44A, 44B), la partie du plot la plus proche du bras comprend une portion allongée dans une direction faisant, en vue de dessus, un angle aigu avec l'axe médian (45A, 45B) du bras.

6. Point mémoire magnétique selon la revendication 5, dans lequel l'angle aigu est compris entre 30° et 60°.

7. Point mémoire magnétique (50 ; 60 ; 70 ; 80 ; 90) selon la revendication 5 ou 6, dans lequel une au moins desdites portions allongées forme une pointe.

8. Point mémoire magnétique (50 ; 60 ; '70 ; 80 ; 90) selon la revendication 5 ou 6, dans lequel une au moins desdites portions allongées forme une pointe arrondie.

9. Point mémoire magnétique (50 ; 60 ; '70 ; 80 ; 90) selon la revendication 8, dans lequel la pointe arrondie a un rayon de courbure compris entre 1 et 10 nm.

10. Point mémoire magnétique (50 ; 60 ; 70) selon l'une quelconque des revendications 5 à 9, dans lequel le plot (51 ; 61 ; 71) a une forme allongée selon un axe (54 ; 66 ; 76) et la piste (52 ; 62 ; 72) est sensiblement coudée à angle droit.

11. Point mémoire magnétique (80 ; 90 ; 100) selon l'une quelconque des revendications 5 à 10, dans lequel le plot a une partie centrale (83 ; 93 ; 103) en forme de rectangle allongé dans le sens de l'un des bras (44E) et disposé près du bord de ce bras le plus proche de l'autre bras.

12. Procédé de programmation d'un point mémoire selon l'une quelconque des revendications 1 à 11, comprenant une étape consistant à faire passer un courant d'un bras à l'autre, le sens du courant étant choisi pour obtenir la programmation souhaitée.

## Patentansprüche

1. Magnetischer Speicherpunkt, umfassend:
einen Kontakt (31; 51; 61; 71; 81; 91; 101), der einen Abschnitt einer magnetischen Schicht (34) zwischen einem Abschnitt einer leitenden Schicht (32) und einem Abschnitt einer nicht magnetischen Schicht (36) aufweist, wobei die magnetische Schicht eine Magnetisierung senkrecht zu der Ebene der Schichten besitzt; und
eine einzelne abgewinkelte Leiterbahn (42; 52; 62; 72; 82; 92; 102), die einen zentralen Abschnitt aufweist, der nur durch zwei Arme (44A, 44B) verlängert ist, wobei der Kontakt vollständig auf der Bahn angeordnet ist,
wobei für jeden Arm ein Strom, der entlang der Mittelachse (45A, 45B) des Arms zu dem Kontakt hin fließt, den Teil des Kontakts sieht, der dem Arm am nächsten liegt, überwiegend auf seiner linken Seite für einen der Arme (44A) und überwiegend auf seiner rechten Seite für den anderen der Arme (44B).

2. Magnetischer Speicherpunkt nach Anspruch 1, wobei sich die leitende Schicht (34) und die nicht magnetische Schicht (36) in ihrer Dicke, ihrer Zusammensetzung oder ihrer Struktur unterscheiden.

3. Magnetischer Speicherpunkt nach Anspruch 1 oder 2, wobei die magnetische Schicht (34) eine Dicke von weniger als 3 nm besitzt.

4. Magnetischer Speicherpunkt (30) nach einem der Ansprüche 1 bis 3, wobei der Kontakt (31) von oben gesehen die Form einer Scheibe besitzt.

5. Magnetischer Speicherpunkt (50; 60; 70; 80; 90; 100) nach einem der Ansprüche 1 bis 3, wobei für jeden Arm (44A, 44B) der Teil des Kontakts, der dem Arm am nächsten liegt, einen Abschnitt umfasst, der sich in einer Richtung ausdehnt, die von oben gesehen einen spitzen Winkel mit der Mittelachse (45A, 45B) des Arms ausbildet.

6. Magnetischer Speicherpunkt nach Anspruch 5, wobei der spitze Winkel zwischen 30° und 60° liegt.

7. Magnetischer Speicherpunkt (50; 60; 70; 80; 90) nach Anspruch 5 oder 6, wobei mindestens einer der ausgedehnten Abschnitte eine Spitze ausbildet.

8. Magnetischer Speicherpunkt (50; 60; '70; 80; 90) nach Anspruch 5 oder 6, wobei mindestens einer der ausgedehnten Abschnitte eine abgerundete Spitze ausbildet.

9. Magnetischer Speicherpunkt (50; 60; 70; 80; 90) nach Anspruch 8, wobei die abgerundete Spitze einen Krümmungsradius zwischen 1 und 10 nm besitzt.

10. Magnetischer Speicherpunkt (50; 60; 70) nach einem der Ansprüche 5 bis 9, wobei der Kontakt (51; 61; 71) eine ausgedehnte Form entlang einer Achse (54; 66; 76) besitzt und die Bahn (52; 62; 72) im Wesentlichen in dem rechten Winkel abgewinkelt ist.

11. Magnetischer Speicherpunkt (80; 90; 100) nach einem der Ansprüche 5 bis 10, wobei der Kontakt einen zentralen Teil (83; 93; 103) in Form eines ausgedehnten Rechtecks in der Richtung des einen der Arme (44E) aufweist und nahe der Kante dieses Arms angeordnet ist, der dem anderen Arm am nächsten liegt.

12. Verfahren zum Programmieren eines Speicherpunkts nach einem der Ansprüche 1 bis 11, umfassend einen Schritt, der darin besteht, einen Strom von einem Arm zu dem anderen zu leiten, wobei die Richtung des Stroms zum Erhalten der gewünschten Programmierung gewählt wird.

## Claims

1. A magnetic memory element, including:
a contact (31; 51; 61; 71; 81; 91; 101) comprising a magnetic layer portion (34) between a conductive layer portion (32) and a nonmagnetic layer portion (36), the magnetic layer having a magnetization perpendicular to the plane of the layers; and
an single angled conductive track (42; 52; 62; 72; 82; 92; 102) comprising a central portion extended by two arms (44A, 44B), the contact being entirely arranged on the track,
wherein, for each arm, a current flowing towards the contact along the median axis (45A, 45B) of the arm encounters the portion of the contact nearest to the arm primarily on the left thereof for one of the arms (44A), and primarily on the right thereof for the other arm (44B).

2. The magnetic memory element according to claim 1, wherein the conductive layer (34) and the nonmagnetic layer (36) differ by their thickness, the composition or their structure.

3. The magnetic memory element according to claim 1 or 2, wherein the magnetic layer (34) has a thickness smaller than 3 nm.

4. The magnetic memory element (30) according to any one of claims 1 to 3, wherein the contact (31) seen from above is disc-shaped.

5. The magnetic memory element (50; 60; 70; 80; 90; 100) according to any one of claims 1 to 3, wherein, for each arm (44A, 44B), the part of the contact closest to the arm comprises a portion elongated in a direction forming, seen from above, an acute angle with the median axis (45A, 45B) of the arm.

6. The magnetic memory element according to claim 5, wherein the acute angle is comprised between 30° and 60°.

7. The magnetic memory element (50; 60; 70; 80; 90) according to claim 5 or 6, wherein at least one of said elongated portions forms a tip.

8. The magnetic memory element (50; 60; 70; 80; 90) according to claim 5 or 6, wherein at least one of said elongated portions forms a rounded tip.

9. The magnetic memory element (50; 60; 70; 80; 90) according to claim 8, wherein the rounded tip has a curve radius comprised between 1 and 10 nm.

10. The magnetic memory element (50; 60; 70) according to any one of claims 5 to 9, wherein the contact (51; 61; 71) has a shape elongated along an axis (54; 66; 76) and the track (52; 62; 72) is substantially angled at a right angle.

11. The magnetic memory element (80; 90; 100) according to any one of claims 5 to 10, wherein the contact has a central part (83; 93; 103) in the form of an elongated rectangle in the direction of one of the arms (44E) and positioned close to the edge of this arm closest to the other arm.

12. A method for programming a memory element according to any one of claims 1 to 11, comprising a step consisting of passing a current from one arm to the other, the direction of the current being chosen to obtain the desired programming.
